# EUROPÄISCHE PATENTSCHRIFT

(11) **EP 1 770 653 B1**
(45) Veröffentlichungstag und Bekanntmachung des Hinweises auf die Patenterteilung: **11.11.2015**
(21) Anmeldenummer: 06020094.6
(22) Anmeldetag: 26.09.2006
(51) Int. Cl.: G07C 9/00, H03K 17/955, H03K 17/96, E05B 1/00

(54) **Auslöseeinrichtung für Kraftfahrzeuge**
Triggering device for vehicles
Dispositif de déclenchement pour véhicules

(30) Priorität: 28.09.2005 DE 102005046542
(43) Veröffentlichungstag der Anmeldung: 04.04.2007
(73) Patentinhaber: Huf Hülsbeck & Fürst GmbH & Co. KG, 42551 Velbert (DE)
(72) Erfinder: Bienek, Bernd, 46145 Oberhausen (DE); Jendritza, Daniel, Dr., 47802 Krefeld (DE); Sandau, Helmut, 42549 Velbert (DE)
(74) Vertreter: Eggers, Thomas Peter

(56) Entgegenhaltungen:
- EP-A1- 1 450 489
- EP-A1- 1 510 637
- EP-A2- 0 954 098
- EP-A2- 1 083 282
- EP-A2- 1 103 675
- EP-A2- 1 512 814
- WO-A1-2005/106163
- DE-A1- 10 346 943
- DE-A1-102005 046 542
- US-A- 5 144 841

## Beschreibung

Die Erfindung betrifft eine Auslöseeinrichtung für Kraftfahrzeuge, beispielsweise zur Betätigung eines Kraftfahrzeugtürverschlusses, mit einer Betätigungseinheit, ferner mit wenigstens einem ersten kapazitiv arbeitenden Sensor, und mit einem zweiten Sensor, wobei beide Sensoren miteinander und mit der Betätigungseinheit verknüpft sind. - Der Begriff "Verknüpfung" drückt aus, dass die Signale beider Sensoren beispielsweise von einer Steueranlage gemeinsam ausgewertet werden und in ein Ausgabesignal münden. Zusätzlich wird dieses Ausgabesignal von der Betätigungseinheit beeinflusst, deren Position, Auslenkung oder allgemein Berührung von einem Bediener mit Hilfe einer oder beider Sensoren erfasst werden.

Eine Auslöseeinrichtung der eingangs beschriebenen Ausführungsform wird in der DE 103 07 673 A1 vorgestellt. Hier sind zwei kapazitiv arbeitende Sensoren realisiert, von denen der erste Sensor als Auslösesensor ausgebildet ist, während der zweite Sensor lediglich auf Umwelteinflüsse reagiert.

Aus der EP 0 954 098 A2 ist ebenfalls eine Auslösevorrichtung bekannt, welche einen kapazitiven und einen piezoelektrischen Sensor umfasst.

Solche Umwelteinflüsse stören insbesondere kapazitiv arbeitende Sensoren, wenn diese in einem Außentürgriff als Betätigungseinheit angeordnet sind. Zu diesem Zweck schlägt die DE 103 46 943 A1 vor, dass eine Anzahl von Fehlauslösungen des betreffenden Sensors eine schlüssellose Türöffnungsvorrichtung deaktiviert. Das ist mit Komforteinbußen verbunden.

Der Erfindung liegt das technische Problem zugrunde, eine Auslöseeinrichtung für Kraftfahrzeuge der eingangs beschriebenen Gestaltung so weiter zu entwickeln, dass die Funktionssicherheit erhöht wird und insbesondere Komforteinbußen - auch bei störenden Umwelteinflüssen - nicht hingenommen zu werden brauchen.

Die Lösung dieser technischen Problemstellung gelingt mit einer Auslöseeinrichtung für Kraftfahrzeuge gemäß dem Anspruch 1.

Piezoelektrische Sensoren an Betätigungseinheiten für Kraftfahrzeuge sind zwar grundsätzlich bekannt, wie beispielsweise die DE 101 32 925 A1 belegt. Hier wird jedoch das Piezoelement einzig und allein zum Erfassen einer Betätigung des Türaußengriffes eingesetzt, findet also ein zusätzlich kapazitiv arbeitender Sensor keine Berücksichtigung. Als Folge hiervon wird eine Zugangsberechtigungsprüfung und ein damit verbundener Frage-/Antwort-Dialog beim schlüssellosen Zutritt (keyless entry) erst dann eingeleitet, wenn ein Bediener die Baueinheit bzw. den Türaußengriff tatsächlich betätigt hat. Das ist mit Nachteilen beim erwähnten Stand der Technik verbunden, die man gerade durch die meistens berührungslos arbeitenden und auf Annäherungen eines Bedieners reagierenden kapazitiven Sensoren bereits überwunden hat.

Denn die gleichsam vorgeschaltete Zugangsberechtigungsprüfung stellt sicher, dass sich beispielsweise ein an die Auslöseeinrichtung angeschlossener Kraftfahrzeugtürverschluss bereits in seiner Stellung "entriegelt" befindet, und zwar bevor der Bediener die Betätigungseinheit bzw. einen Türaußengriff beaufschlagt. Dagegen muss die Einnahme der Stellung "entriegelt" beim Stand der Technik der DE 101 32 925 zunächst abgewartet werden, was insgesamt als unkomfortabel beurteilt wird. Nichts anderes gilt für die ähnlich zu bewertende DE 103 09 148 A1.

Im Gegensatz dazu sind die beiden Sensoren miteinander verknüpft, und zwar logisch und/oder zeitlich. Im erstgenannten Fall ist eine "ODER"-Verknüpfung dergestalt denkbar, dass bei Betätigung eines der beiden Sensoren ein entsprechendes Ausgabesignal erzeugt wird. Meistens wird man jedoch ergänzend oder alternativ mit einer zeitlichen Abfrage arbeiten. So wird ein Signal des üblicherweise als Näherungssensor ausgeführten ersten Sensors in der Regel dahingehend interpretiert, dass der bereits angesprochene Frage-/Antwort-Dialog im Rahmen einer Zugangsberechtigungsprüfung beim "keyless entry" eingeleitet wird. Als Folge hiervon wird im Beispielfall der angeschlossene Kraftfahrzeugtürverschluss in die Stellung "entriegelt" überführt. Sofern innerhalb einer vorgegebenen Zeitspanne, beispielsweise 5 Sekunden oder 10 Sekunden, ein Bediener die Betätigungseinheit beaufschlagt, registriert dies der zweite Sensor, welcher üblicherweise als taktiler Sensor zum Erfassen einer Berührung und/oder Betätigung der Betätigungseinheit ausgestaltet ist. Wird das besagte Zeitfenster eingehalten, so kann der Bediener den bereits entriegelten Kraftfahrzeugtürverschluss unmittelbar öffnen.

Kommt es jedoch innerhalb der angegebenen Zeitspanne nicht zu dem zweiten Signal vom dem zweiten arbeitenden Sensor, so wird man in der Regel den zugehörigen Kraftfahrzeugtürverschluss wieder in die Stellung "verriegelt" überführen (nachdem er zuvor die Position "entriegelt" eingenommen hat). Ähnliches geschieht, wenn der Näherungssensor durch Umwelteinflüsse oder dergleichen gestört ist. Denn dann fehlt das zweite Signal des zweiten Sensors innerhalb der angegebenen Zeitspanne, so dass der Kraftfahrzeugtürverschluss (wieder) seine Position "verriegelt" einnimmt.

Erfindungsgemäß ist es in diesem Zusammenhang zusätzlich, dass bei ständig wechselnden Umwelteinflüssen bzw. wiederholten Fehlsignalen am ersten kapazitiv arbeitenden Sensor nur dieser kapazitiv arbeitende Sensor für eine bestimmte Zeit deaktiviert wird. Dann ist einzig und allein der zweite piezoelektrisch bzw. piezoresistiv arbeitende Sensor für die Beaufschlagung des Kraftfahrzeugtürverschlusses verantwortlich. Sofern als Folge eines von ihm erzeugten Ausgabesignals der angeschlossene Kraftfahrzeugtürverschluss beispielsweise elektrisch geöffnet wird, resultiert dieser Umstand nicht in Komforteinbußen, weil beim elektrischen Öffnen der Kraftfahrzeugtürverschluss zuvor nicht entriegelt zu werden braucht. Auch wenn diese Funktion nicht vorliegt, muss dennoch der Kraftfahrzeugtürverschluss nicht mechanisch geöffnet werden, sondern gelingt unverändert ein schlüsselloser Zugang - mit allenfalls geringfügig verzögerter Öffnung aufgrund des erst durch den zweiten Sensor ausgelösten Frage-/Antwort-Dialoges.

Üblicherweise formen die beiden Sensoren eine Baueinheit und lassen sich dadurch besonders kostengünstig herstellen. Dabei hat es sich bewährt, wenn beide Sensoren auf einem gemeinsamen Träger angebracht sind. Dieser Träger kann vorteilhaft aus Kunststoff gefertigt sein bzw. als Kunststofffolie ausgebildet sein.

Sofern der kapazitive Sensor wenigstens eine elektrisch leitfähige Schicht als Elektrode aufweist, lässt sich diese elektrisch leitfähige Schicht problemlos auf den vorerwähnten Träger bzw. die Kunststofffolie oder Leiterbahnfolie aufbringen, nämlich durch Aufdrucken, Aufdampfen, Aufkaschieren etc.. Auch der piezoelektrisch sowie piezoresistiv arbeitende Sensor liegt - wie der kapazitive Sensor - als Schichtsensor vor. Der piezoresistiv arbeitende Sensor kann dabei im günstigsten Fall durch die elektrisch leitfähigen Schichten des kapazitiven Sensors gebildet sein.

Der piezoresistiv arbeitendende Sensors zeichnet sich dadurch aus, dass dieser unter mechanischen Belastungen (Zug - Druck) seinen elektrischen Widerstand ändert. Diese Widerstandsänderung kann über eine elektrische Schaltung (Wheatstonesche Brücke), die ebenfalls in der Baueinheit angeordnet sein kann, erfaßt und zur quantitativen Beurteilung der belastungsbedingten Verformung herangezogen werden.

Im Fall des piezolelektrisch arbeitenden Sensors kommt eine elektrisch isolierende Schicht mit eingelagerten Piezokristallen bzw. piezoelektrischen Molekülen zum Einsatz, die auch als Piezolack bezeichnet wird. Wenn an einen solchen meistens als Polymerlack ausgebildeten Piezolack eine elektrische Spannung angelegt wird, werden die eingelagerten Piezokristalle polarisiert. Die zuvor statisch ausgerichteten piezoelektrischen Moleküle bzw. Piezokristalle werden durch die angelegte Spannung folglich ausgerichtet. Jede mechanische Einwirkung auf die Piezokristalle durch beispielsweise Druck führt nun dazu, dass sich die anliegende elektrische Spannung ändert und folglich den ausgeübten Druck bzw. die Berührung sensiert.

In der Regel ist der piezoelektrische Sensor bzw. die hierzu gehörige elektrisch isolierende Schicht mit den eingelagerten Piezokristallen zwischen zwei elektrisch leitenden Schichten bzw. Elektroden angeordnet, um die beschriebene Spannung an den Piezolack anlegen zu können bzw. die gewünschte Polarisation der Piezokristalle zu erreichen. Der Piezolack ist zwischen den besagten Elektroden wie ein Elektrolyt zwischen Kondensatorflächen eingebettet. Ändert sich die Polarisation des Elektrolyten durch die Druckbeaufschlagung, so folgt die anliegende Spannung und ist damit ein Maß für die Beanspruchung.

Beide elektrische leitfähigen Schichten bilden ferner zusammengenommen den kapazitiven Sensor. Auf diese Weise kommt dem kapazitiven Sensor bzw. den zugehörigen beiden elektrisch leitfähigen Schichten oder Elektroden eine zweifache Funktion zu. Zunächst einmal lassen sich mit ihrer Hilfe Annäherungen einer Bedienperson erfassen, die gleichsam als Gegenelektrode wirkt. Das heißt, die Bedienperson und wenigstens eine oder beide der vorgenannten Elektroden bilden zusammengenommen einen Kondensator, dessen Kapazität sich in Abhängigkeit vom Abstand der Bedienperson ändert. Nähere Details hierzu finden sich in der EP 1 235 190 A1, auf die ausdrücklich verwiesen sei.

Neben dieser Funktion als Näherungssensor kommt den beiden elektrisch leitfähigen Schichten bzw. Elektroden des kapazitiven Sensors die weitere Funktion zu, die zwischen ihnen befindliche elektrisch isolierende Schicht mit den eingelagerten Piezokristallen im Hinblick auf Berührungen oder Druckbeanspruchungen zu sensieren.

Denn die Elektroden sorgen für die notwendige Polarisation der in die elektrisch isolierende Schicht eingelagerten Piezokristalle. Wenn nun auf die Baueinheit aus den beiden Sensoren bzw. die elektrisch isolierende Schicht mit den eingelagerten Piezokristallen bzw. den Piezolack ein Druck ausgeübt wird, so kommt es zu einer Ladungsverschiebung der Piezokristalle, die sich als (geringe) Ausgangsspannung bzw. Änderung der Ausgangsspannung an den beiden Elektroden bemerkbar macht. Tatsächlich liegen die Änderungen im Mikrovoltbereich, wobei bereits Kräfte von einem Newton oder weniger erfasst werden.

Die beiden bzw. drei Schichten können vorteilhaft übereinander angeordnet auf dem gemeinsamen Träger angebracht werden. Da sich die jeweiligen Schichtdicken deutlich unterhalb von 100 µm bewegen, ist die Baueinheit insgesamt äußert kompakt aufgebaut und verfügt über eine gesamte Schichtdicke von in der Regel weniger als 1 mm. Auf diese Weise lässt sich der Träger zusammen mit den Sensoren als quasi beschichtetes Kunststoff-Folienaggregat problemlos im Innern einer Betätigungseinheit platzieren, und zwar auch dann, wenn hier nur begrenzter Bauraum zur Verfügung steht.

Dabei empfiehlt es sich, die Baueinheit aus den beiden Sensoren in der Betätigungseinheit hermetisch abgeschlossen anzuordnen. Üblicherweise steht hierzu ein Hohlraum in der Betätigungseinheit zur Verfügung, in welchen die Baueinheit eingebracht und mit einer Gießmasse vergossen wird. Dadurch wird ein besonders zuverlässiger und langlebiger Betrieb erreicht.

Im Ergebnis wird eine Auslöseeinrichtung für Kraftfahrzeuge zur Verfügung gestellt, die besonders funktionssicher arbeitet. Dazu trägt die Kombination des ersten kapazitiv arbeitenden Sensors mit dem zweiten piezoelektrisch oder piezoresistiv arbeitenden Sensor gemäß Anspruch 1 bei. Auf diese Weise werden auch kurzfristig sich ändernde Umweltbedingungen erfasst und führen nicht zu gravierenden Komforteinbußen. Hierin sind die wesentlichen Vorteile zu sehen.

Im Folgenden wird die Erfindung anhand einer lediglich ein Ausführungsbeispiel darstellenden Zeichnung näher erläutert; es zeigen:
- **Fig. 1**: die Auslöseeinrichtung schematisch und
- **Fig. 2**: ein Zeitdiagramm als Beispiel.

In den Figuren ist eine Auslöseeinrichtung für Kraftfahrzeuge dargestellt. Diese Auslöseeinrichtung dient vorliegend dazu, einen Kraftfahrzeugtürverschluss 1 in einer Kraftfahrzeugkarosserie bzw. in einem Kraftfahrzeug 2 zu betätigen. Hierbei handelt es sich jedoch ausdrücklich um einen nicht einschränkenden Beispielfall. Denn die Auslöseeinrichtung kann selbstverständlich auch an völlig anderer Stelle genutzt werden, beispielsweise dazu, den Motor zu starten oder dergleichen.

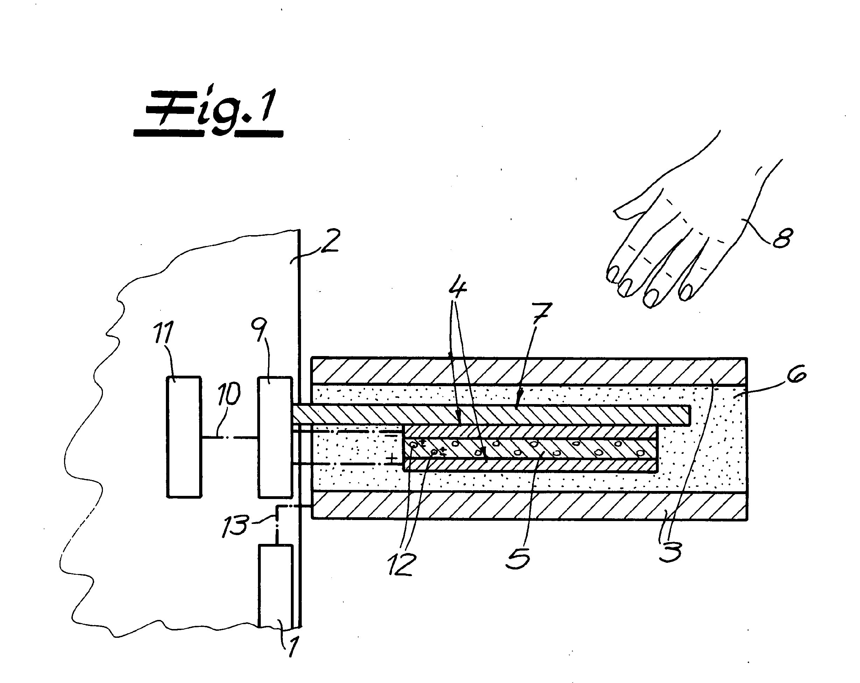

Die Auslöseeinrichtung setzt sich in ihrem grundsätzlichen Aufbau aus einer Betätigungseinheit 3 sowie zwei Sensoren 4, 5 zusammen. Bei der Betätigungseinheit 3 handelt es sich - ebenfalls nicht einschränkend - um einen Türaußengriff 3, welcher in der Fig. 1 im schematischen Längsschnitt dargestellt ist. Bei dem ersten Sensor 4 handelt es sich um einen kapazitiv arbeitenden Sensor, während der zweite Sensor 5 erfindungsgemäß piezoelektrisch oder piezoresistiv arbeitet, wie nachfolgend noch näher erläutert wird.

Nach einer Ausführungsform der Erfindung gemäß Anspruch 1 erkennt man, dass beide Sensoren 4, 5 eine Baueinheit formen, die insgesamt in einem Hohlraum 6 der Betätigungseinheit 3 Platz findet. Damit die Sensoren 4, 5 bzw. die Baueinheit 4, 5 nicht durch äußere Einflüsse gestört wird, ist der Hohlraum 6 nach Einbringen der Baueinheit 4, 5 mit einer angedeuteten Gießmasse ausgefüllt worden. Die Gießmasse sorgt nicht nur für einen feuchtigkeitsdichten Abschluss und eine elektrische Isolierung sondern leitet auch Verformungen oder Betätigungskräfte an den piezoelektrischen Sensor 5 weiter. Man erkennt, dass beide Sensoren 4, 5 auf einem gemeinsamen Träger 7 angebracht sind, bei dem es sich um einen Träger aus Kunststoff, beispielsweise eine Kunststofffolie oder eine Leiterbahnfolie handelt.

Im Detail setzt sich der kapazitive Sensor 4 aus zwei elektrisch leitfähigen Schichten als Elektroden zusammen, die zwischen sich den piezoelektrischen Sensor 5 aufnehmen. Der piezoelektrische Sensor 5 ist - wie die kapazitiven Sensoren 4 - ebenfalls als Schichtsensor ausgeführt und greift auf eine elektrisch isolierende Schicht mit eingelagerten Piezokristallen zurück. Sämtliche Schichten bzw. Schichtsensoren 4, 5 werden durch Aufdrucken, Bedampfen, Auftragen, Aufrakeln, Aufkleben etc. auf den gemeinsamen Träger 7 aufgebracht, und zwar im Rahmen der Darstellung auf die Unterseite des Trägers 7, was natürlich nur beispielhaft gilt.

Die beiden Sensoren bzw. Schichten 4, 5 sind übereinander angeordnet auf dem besagten Träger 7 aufgebracht, wobei der piezoelektrisch arbeitende Sensor 5 von den beiden Elektroden 4 des kapazitiven Sensors 4 eingeschlossen wird. Dadurch können die solchermaßen gebildeten Elektroden 4 auf Annäherungen einer Hand 8 eines Bedieners reagieren. Denn diese Hand 8 wirkt im Vergleich zu den Elektroden 4 als Gegenelektrode und Annäherungen ändern die Kapazität des solchermaßen gebildeten Kondensators 4, 8.

Die beschriebenen Kapazitätsänderungen werden von einer über einen Stecker 9 und eine Zuleitung 10 im Innern der Kraftfahrzeugkarosserie befindliche Auswerteeinheit 11 erfasst. Neben diesen Kapazitätsänderungen sorgen die beiden Elektroden 4 und eine an ihnen anliegende Spannung dafür, dass die in die elektrisch isolierende Schicht eingelagerten und lediglich angedeuteten Piezokristalle 12 des piezoelektrischen Sensors 5 polarisiert werden. Das heißt, die einzelnen Piezokristalle bzw. ihr Kristallgitter erfährt die in der Fig. 1 angedeutete Polarisation. Falls nun auf den piezoelektrischen Sensor 5 Druck ausgeübt wird, so ändert sich durch den piezoelektrischen Effekt diese Polarisation zusätzlich und führt zu einer (geringfügigen) Spannungsänderung an den Elektroden 4, die von der Auswerteeinheit 11 als Sensorauslösung interpretiert wird.

Eine solche Auslösung des piezoelektrischen Sensors 5 korrespondiert beispielsweise dazu, dass die Bedienerhand 8 die Betätigungseinheit 3 berührt oder umgriffen hat, um im Beispielfall den Kraftfahrzeugtürverschluss 1 zu öffnen. Dabei mag jede noch so geringe Auslenkung der Betätigungseinheit 3 vom dem piezoelektrischen Sensor 5 erfasst werden.

Als Folge hiervon kann der Kraftfahrzeugtürverschluss 1 (welcher zuvor bereits in die Stellung "entriegelt" verbracht wurde) durch eine lediglich angedeutete mechanische Verbindung 13 mit Hilfe der Betätigungseinheit 3 bzw. dem Türaußengriff geöffnet werden. Bei dieser mechanischen Verbindung mag es sich um einen Bowdenzug, ein Gestänge usw. handeln.

Der Träger 7 bildet zusammen mit den Sensoren 4, 5 ein Kunststoff-Folienaggregat 4, 5, 7, welches insgesamt in dem bereits angesprochenen Hohlraum 6 der Betätigungseinheit 3 Platz findet. Dabei ist der erste Sensor bzw. kapazitiv arbeitende Sensor 4 als Näherungssensor ausgebildet und leitet wie beschrieben einen Frage-/Antwort-Dialog im Rahmen einer Zugangsberechtigungsprüfung eines Bedieners 8 ein. Dagegen fungiert der zweite Sensor 5 als taktiler Sensor und erfasst Berührungen und/oder eine Betätigung der Betätigungseinheit 3.

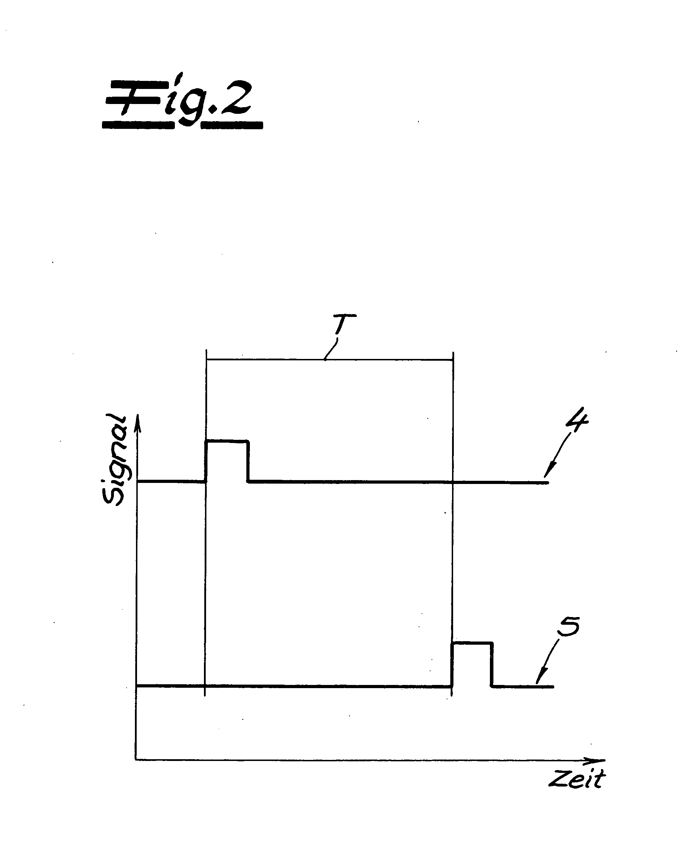

Um Fehlfunktionen der Betätigungseinheit 3 auszuschließen, kann die in Fig. 2 angegebene Zeitabfrage vorgenommen werden. Dort sind die beiden Signale der Sensoren 4, 5 in einer zeitlichen Abfolge dargestellt. Man erkennt im oberen Teil der Fig. 2 das vom kapazitiven ersten Sensor 4 erzeugte erste Signal und im unteren Teil der Fig. 2 das zugehörige zweite Signal des zweiten piezoelektrisch arbeitenden Sensors 5. Etwaige Umwelteinflüsse, welche die Sensierung des kapazitiv arbeitenden Sensors 4 stören könnten, werden nun dadurch erfasst und beherrscht, dass zwischen dem Auftreten der beiden Sensorsignale ein bestimmter Zeitraum T gemessen wird.

Liegt dieser Zeitraum T innerhalb einer bestimmten Zeitspanne (beispielsweise 5 Sekunden oder 10 Sekunden), so wird die im Anschluss an eine erfolgreiche Zugangsberechtigungsprüfung bereits vorgenommene Entriegelung des Kraftfahrzeugtürverschlusses 1 im Beispielfall beibehalten. Findet jedoch innerhalb des Zeitraumes T keine Beaufschlagung der Betätigungseinheit 3 statt, so dass das zweite Signal des zweiten Sensors 5 fehlt, so wird der Kraftfahrzeugtürverschluss 1 wieder in seine Stellung "verriegelt" überführt. Bei mehreren Fehlauslösungen des kapazitiven ersten Sensors 4 kann dieser auch (für eine bestimmte Zeit) deaktiviert werden. Dann sorgt einzig und allein der zweite Sensor 5 dafür, dass der Kraftfahrzeugtürverschluss 1 geöffnet wird, und zwar nach dem durch ihn die Zugangsberechtigungsprüfung zunächst eingeleitet worden ist. Beide Sensoren 4, 5 arbeiten insofern also redundant.

Nach einer nicht erfindungsgemäßen Ausführungsform elektrisch leitfähigen Schichten des kapazitiven Sensors 4, 5 gleichzeitig die Sensorschicht des piezoresistiven Sensors. Die Schicht 5 nimmt dabei lediglich die Funktion eines isolierten Abstandshalters ein. Aufgrund der Tatsache, dass die in den Hohlraum 6 des Türaussengriffes befindliche Baueinheit 4, 5 von einer Gießmasse umschlossen ist, werden Betätigungskräfte oder Verformungen des Türaußengriffes auf die Baueinheit 4, 5 übertragen. Diese Verformungen werden von dem piezoresistiven Sensor in Form einer elektrischen Widerstandsänderung erkannt und an eine hier nicht dargestellte elektrische Schaltung weitergeleitet. Die Verformung des Türausengriffes und der damit verbundenen Auslösung des piezoresistiven Sensors 4 korrespondiert dabei entweder bei aktiven kapazitiven Sensor 4, 5 mit einer elektrischen Öffnung und / oder Ent- oder Verriegelung eines Kraftfahrzeugtürverschlusses 1 oder bei inaktiven kapazitiven Sensor 4, 5 (zuvor) mit einer Einleitung eines Frage-Antwort-Dialoges im Rahmen einer Zugangsberechtigungsüberprüfung.

## Patentansprüche

1. Auslöseeinrichtung für Kraftfahrzeuge (2), beispielsweise zur Betätigung eines Kraftfahrzeugtürverschlusses (1), mit einer Betätigungseinheit (3), ferner mit wenigstens einem ersten kapazitiv arbeitenden Sensor (4), und mit einem piezoelektrisch oder piezoresistiv arbeitenden zweiten Sensor (5), wobei beide Sensoren (4, 5) miteinander logisch und/oder zeitlich verknüpft sind und mit der Betätigungseinheit (3) verknüpft sind und die Sensoren (4,5) redundant arbeiten, **dadurch gekennzeichnet, dass** bei wiederholten Fehlsignalen am ersten kapazitiv arbeitenden Sensor (4) nur dieser kapazitiv arbeitende Sensor (4) für eine bestimmte Zeit deaktiviert wird.

2. Auslöseeinrichtung nach Anspruch 1, **dadurch gekennzeichnet, dass** die beiden Sensoren (4, 5) eine Baueinheit (4, 5) formen.

3. Auslöseeinrichtung nach Anspruch 1 oder 2, **dadurch gekennzeichnet, dass** beide Sensoren (4, 5) auf einem gemeinsamen Träger (7) angebracht sind.

4. Auslöseeinrichtung nach einem der Ansprüche 1 bis 3, **dadurch gekennzeichnet, dass** der kapazitive Sensor (4) wenigstens eine elektrisch leitfähige Schicht (4) als Elektrode aufweist.

5. Auslöseeinrichtung nach einem der Ansprüche 1 bis 4, **dadurch gekennzeichnet, dass** der piezoelektrische Sensor (5) wenigstens eine elektrisch isolierende Schicht (5) mit eingelagerten Piezokristallen (12) aufweist.

6. Auslöseeinrichtung nach einem der Ansprüche 1 bis 4, **dadurch gekennzeichnet, dass** der piezoresistive Sensor durch die wenigstens eine elektrisch leitfähige Schicht des kapazitiven Sensors (4) gebildet wird.

7. Auslöseeinrichtung nach einem der Ansprüche 1 bis 6, **dadurch gekennzeichnet, dass** die beiden Schichten (4, 5) übereinander angeordnet auf dem Träger (7) angebracht sind.

8. Auslöseeinrichtung nach einem der Ansprüche 1 bis 7, **dadurch gekennzeichnet, dass** der Träger (7) zusammen mit den Sensoren (4, 5) ein Kunststoff-Folienaggregat (4, 5, 7) bildet, welches beispielsweise in einem Hohlraum (6) der Betätigungseinheit (3) aufgenommen wird.

9. Auslöseeinrichtung nach einem der Ansprüche 1 bis 8, **dadurch gekennzeichnet, dass** die Baueinheit (4, 5) aus den beiden Sensoren (4, 5) in der Betätigungseinheit (3) hermetisch abgeschlossen, beispielsweise in Gießmasse eingebettet, aufgenommen wird.

10. Auslöseeinrichtung nach einem der Ansprüche 1 bis 9, **dadurch gekennzeichnet, dass** der erste Sensor (4) als Näherungssensor ausgebildet ist und einen Frage-/Antwort-Dialog im Rahmen einer Zugangsberechtigungsprüfung einleitet.

11. Auslöseeinrichtung nach einem der Ansprüche 1 bis 10, **dadurch gekennzeichnet, dass** der zweite Sensor (4, 5) als taktiler Sensor zum Erfassen einer Berührung und/oder eine Betätigung der Betätigungseinheit (3) ausgebildet ist.

12. Auslöseeinrichtung nach einem der Ansprüche 1 bis 11, **dadurch gekennzeichnet, dass** durch ein durch den zweiten Sensor (4, 5) erzeugtes Ausgabesignal der Kraftfahrzeugtürverschluss (1) elektrisch geöffnet wird.

13. Auslöseeinrichtung nach einem der Ansprüche 1 bis 11, **dadurch gekennzeichnet, dass** durch ein durch den zweiten Sensor (4, 5) erzeugtes Ausgabesignal der Kraftfahrzeugtürverschluss (1) ent- oder verriegelt wird.

## Claims

1. A release device for motor vehicles (2), for example for the actuation of a motor vehicle door lock (1), with an actuation unit (3), also with at least one first capacitively operating sensor (4), and one piezoelectrically or piezoresistively operating second sensor (5), wherein the two sensors (4, 5) are linked with one another logically and/or temporally, and are linked with the actuation unit (3), and the sensors (4, 5) operate in a redundant manner, **characterised in that**, in the event of repeated false signals on the first capacitively operating sensor (4), only the said capacitively operating sensor (4) is deactivated for a certain period of time.

2. The release device in accordance with Claim 1, **characterised in that**, the two sensors (4, 5) form a unit (4, 5).

3. The release device in accordance with Claim 1 or 2, **characterised in that**, the two sensors (4, 5) are fitted to a common support (7).

4. The release device in accordance with one of the Claims 1 to 3, **characterised in that**, the capacitive sensor (4) has at least one electrically conductive layer (4) as an electrode.

5. The release device in accordance with one of the Claims 1 to 4, **characterised in that**, the piezoelectric sensor (5) has at least one electrically insulating layer (5) with embedded piezo crystals (12).

6. The release device in accordance with one of the Claims 1 to 4, **characterised in that**, the piezoresistive sensor is formed by the at least one electrically conductive layer of the capacitive sensor (4).

7. The release device in accordance with one of the Claims 1 to 6, **characterised in that**, the two layers (4, 5) are fitted to the support (7), arranged one above another.

8. The release device in accordance with one of the Claims 1 to 7, **characterised in that**, the support (7) together with the sensors (4, 5) forms a plastic film unit (4, 5, 7), which is accommodated, for example, in a cavity (6) of the actuation unit (3).

9. The release device in accordance with one of the Claims 1 to 8, **characterised in that**, the unit (4, 5) comprising the two sensors (4, 5) is accommodated in the actuation unit (3) in an hermetically sealed manner, embedded, for example, in a casting compound.

10. The release device in accordance with one of the Claims 1 to 9, **characterised in that**, the first sensor (4) is designed as a proximity sensor, and initiates a question-and-answer dialogue within the context of an access authorisation check.

11. The release device in accordance with one of the Claims 1 to 10, **characterised in that**, the second sensor (4, 5) is designed as a tactile sensor for purposes of registering a contact, and/or an actuation of the actuation unit (3).

12. The release device in accordance with one of the Claims 1 to 11, **characterised in that**, the motor vehicle door lock (1) is electrically opened by means of an output signal generated by the second sensor (4, 5).

13. The release device in accordance with one of the Claims 1 to 11, **characterised in that**, the motor vehicle door lock (1) is unlocked or locked by means of an output signal generated by the second sensor (4, 5).

## Revendications

1. Dispositif de déclenchement pour véhicules automobiles (2), par exemple pour l'actionnement d'une serrure de porte de véhicule automobile (1), comportant une unité d'actionnement (3), comportant en outre au moins un premier capteur (4) fonctionnant de manière capacitive et comportant un deuxième capteur (5) fonctionnant de manière piézoélectrique ou piézorésistive, dans lequel les deux capteurs (4, 5) sont interconnectés logiquement et/ou temporellement les uns aux autres et sont interconnectés avec l'unité d'actionnement (3) et les capteurs (4, 5) fonctionnent de manière redondante, **caractérisé en ce que** en cas de signaux d'erreur répétés sur le premier capteur (4) fonctionnant de manière capacitive seul ce capteur (4) fonctionnant de manière capacitive est désactivé pendant une durée déterminée.

2. Dispositif de déclenchement selon la revendication 1, **caractérisé en ce que** les deux capteurs (4, 5) forment une unité structurelle (4, 5).

3. Dispositif de déclenchement selon la revendication 1 ou 2, **caractérisé en ce que** les deux capteurs (4, 5) sont montés sur un support commun (7).

4. Dispositif de déclenchement selon une des revendications 1 à 3, **caractérisé en ce que** le capteur capacitif (4) présente au moins une couche électriquement conductrice (4) comme électrode.

5. Dispositif de déclenchement selon une des revendications 1 à 4, **caractérisé en ce que** le capteur piézoélectrique (5) présente au moins une couche électriquement isolante (5) avec des piézo cristaux enrobés (12).

6. Dispositif de déclenchement selon une des revendications 1 à 4, **caractérisé en ce que** le capteur piézorésistif est formé par au moins une couche électriquement conductrice du capteur capacitif (4).

7. Dispositif de déclenchement selon une des revendications 1 à 6, **caractérisé en ce que** les deux couches (4, 5) sont appliquées en étant disposées l'une sur l'autre sur le support (7).

8. Dispositif de déclenchement selon une des revendications 1 à 7, **caractérisé en ce que** le support (7) forme conjointement aux capteurs (4, 5) un ensemble de films pastique (4, 5, 7), qui est par exemple renfermé dans un espace creux (6) de l'unité d'actionnement (3).

9. Dispositif de déclenchement selon une des revendications 1 à 8, **caractérisé en ce que** l'unité structurelle (4, 5) composée des deux capteurs (4, 5) est renfermée dans l'unité d'actionnement (3) de manière hermétiquement isolée, par exemple incorporée dans une masse coulée.

10. Dispositif de déclenchement selon une des revendications 1 à 9, **caractérisé en ce que** le premier capteur (4) est réalisé comme un capteur de proximité et amorce un dialogue question/réponse dans le cadre d'un contrôle d'autorisation d'accès.

11. Dispositif de déclenchement selon une des revendications 1 à 10, **caractérisé en ce que** le deuxième capteur (4, 5) est réalisé comme un capteur tactile pour détecter un contact et/ou un actionnement de l'unité d'actionnement (3).

12. Dispositif de déclenchement selon une des revendications 1 à 11, **caractérisé en ce que** la serrure de porte de véhicule (1) est ouverte électriquement par un signal de sortie généré par le deuxième capteur (4, 5).

13. Dispositif de déclenchement selon une des revendications 1 à 11, **caractérisé en ce que** la serrure de porte de véhicule (1) est verrouillée ou déverrouillée par un signal de sortie généré par le deuxième capteur (4, 5).
